# EUROPEAN PATENT APPLICATION

(11) **EP 4 303 655 A1**
(43) Date of publication of application: **10.01.2024**
(21) Application number: 22182745.4
(22) Date of filing: 04.07.2022
(51) Int. Cl.: G03F 1/62, G03F 7/20, G02B 5/20, G02B 27/14

(54) **A MEMBRANE AND ASSOCIATED METHOD AND APPARATUS**

(71) Applicant: ASML Netherlands B.V., 5500 AH Veldhoven (NL)
(72) Inventor: VAN DER POST, Sietse, Thijmen, 5500 AH Veldhoven (NL); EDWARD, Stephen, 5500 AH Veldhoven (NL); O'DWYER, David, 5500 AH Veldhoven (NL); REININK, Johan, 5500 AH Veldhoven (NL)
(74) Representative: ASML Netherlands B.V.

(57) **Abstract**

Disclosed is a pellicle membrane comprising three or more layers, the three or more layers comprising at least one inner layer and at least one outer layer on either side of said at least one inner layer, wherein the at least one inner layer comprises and/or consists of one or more of boron, zirconium, beryllium, niobium, yttrium, molybdenum and/or carbon and/or one or more compounds of each of these materials. Also disclosed is a metrology apparatus which uses such a pellicle membrane as a beamsplitter and/or filter.

## Description

### FIELD

The present invention relates to metrology applications in the manufacture of integrated circuits.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k₁ lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

In lithographic processes, as well as other manufacturing processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field. The manufacturing processes may be for example lithography, etching, deposition, chemical mechanical planarization, oxidation, ion implantation, diffusion or a combination of two or more of them.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modern product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads is also known, but it provides only indirect evidence of the true product structure.

By decreasing the wavelength of the radiation used during metrology (e.g. moving towards the "soft X-ray (SXR)" wavelength spectrum), it is possible to resolve smaller structures, to increase sensitivity to structural variations of the structures and/or penetrate further into the product structures. One such method of generating suitably high frequency radiation (e.g., hard Xray, soft X-ray and/or EUV radiation) may be using a pump radiation (e.g., infrared IR radiation) to excite a generating medium, thereby generating an emitted radiation, optionally a high harmonic generation comprising high frequency radiation.

In a metrology tool, it is desirable to split the source radiation into a main illumination branch and into a reference sub-branch. The reference sub-branch may be used to monitor the source spectrum or obtain information regarding the source spectrum which can be used to infer a value for a parameter of interest when measuring a structure using the measurement tool. This splitting can be difficult when SXR or EUV radiation is used as the measurement radiation. A grating can be used, but then it is difficult to keep the transmission of the measurement radiation high and the scattering low. Moreover, including a grating in the illumination path puts extra constraints on the optical design, making it more difficult to optimize this design for other system requirements.

It would be desirable to obtain an improved splitting of source illumination into a main illumination branch and into a reference sub-branch.

### SUMMARY

In a first aspect of the invention there is provided a metrology apparatus comprising: an illumination branch comprising illumination optics for directing a measurement radiation beam onto said structure; a pellicle beamsplitter in said illumination branch, said pellicle beamsplitter comprising a pellicle membrane operable to split a source radiation beam from an illumination source into a reference radiation beam and said measurement radiation beam; a measurement detector for detecting said measurement radiation beam subsequent to it being scattered by said structure; and a reference detector for detecting said reference radiation beam.

In a second aspect of the invention, there is provided a pellicle membrane comprising three or more layers, the three or more layers comprising at least one inner layer and at least one outer layer on either side of said at least one inner layer, wherein the at least one inner layer comprises and/or consists of boron, zirconium, beryllium, niobium, yttrium, molybdenum and/or carbon and/or one or more compounds of each of these materials.

In a third aspect of the invention, there is provided a pellicle membrane comprising three or more layers, the three or more layers comprising at least one inner layer and at least one outer layer on either side of said at least one inner layer, wherein the at least one inner layer comprises and/or consists of one or more of silicon, boron, zirconium, beryllium, niobium, yttrium, molybdenum and/or carbon and/or one or more compounds of each of these materials; and a thickness of said at least one outer layer on each side of the at least one inner layer is between 1 nm and 3nm.

In a fourth aspect of the invention, there is provided a filter membrane comprising at least two materials, wherein at least a first material of said at least two materials comprises or consists of germanium or selenium.

In a fifth aspect of the invention, there is provided a method for detecting damage and/or contamination on an irradiated area caused by a radiation.

The above and other aspects of the invention will be understood from a consideration of the examples described below.

### BRIEF DESCRIPTION OF THE DRAWINGS

Embodiments will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 depicts a schematic representation of a metrology apparatus in which EUV and/or SXR radiation is used;
- Figure 6 depicts a simplified schematic drawing of an illumination source, which may be the illumination source for high harmonic generation for a metrology apparatus such as that illustrated in Figure 5;
- Figure 7 comprises (a) a schematic diagram of a dark field scatterometer for use in measuring targets according to embodiments of the invention using a first pair of illumination apertures, (b) a detail of diffraction spectrum of a target grating for a given direction of illumination (c) a second pair of illumination apertures providing further illumination modes in using the scatterometer for diffraction based overlay measurements and (d) a third pair of illumination apertures combining the first and second pair of apertures;
- Figure 8 is a schematic illustration of a metrology apparatus of known configuration;
- Figure 9 is a schematic illustration of a metrology apparatus according to an embodiment;
- Figure 10(a) is a plot of transmission Trn against wavelength λ for a zirconium filter;

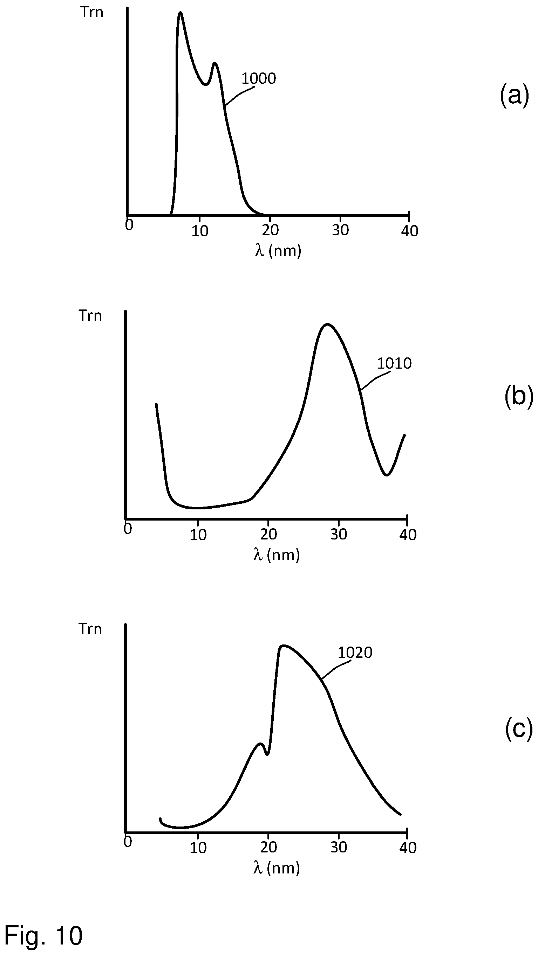

- Figure 10(a) is a plot of transmission Trn against wavelength λ for a germanium filter;
- Figure 10(a) is a plot of transmission Trn against wavelength λ for a selenium filter; and

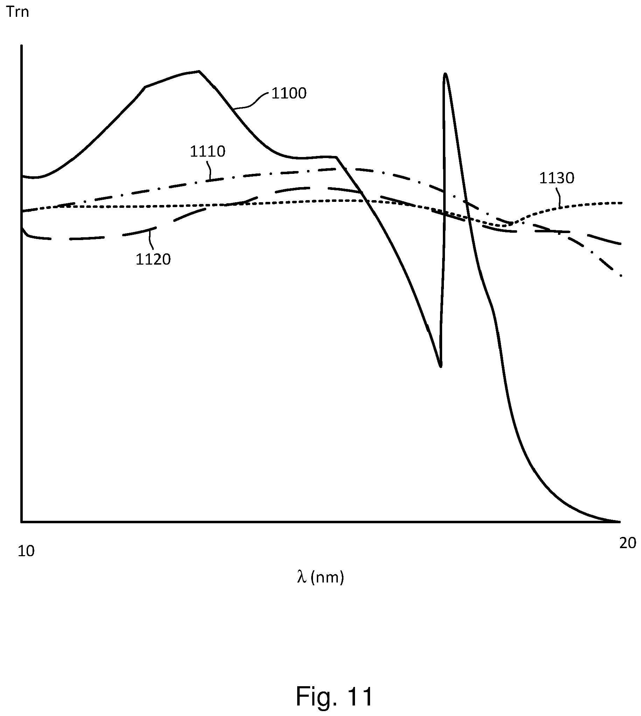

- Figure 11 is a plot of transmission Trn against wavelength λ for each of a germanium and zirconium filter, a selenium and copper filter and a boron, germanium and zirconium filter.

### DETAILED DESCRIPTION

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

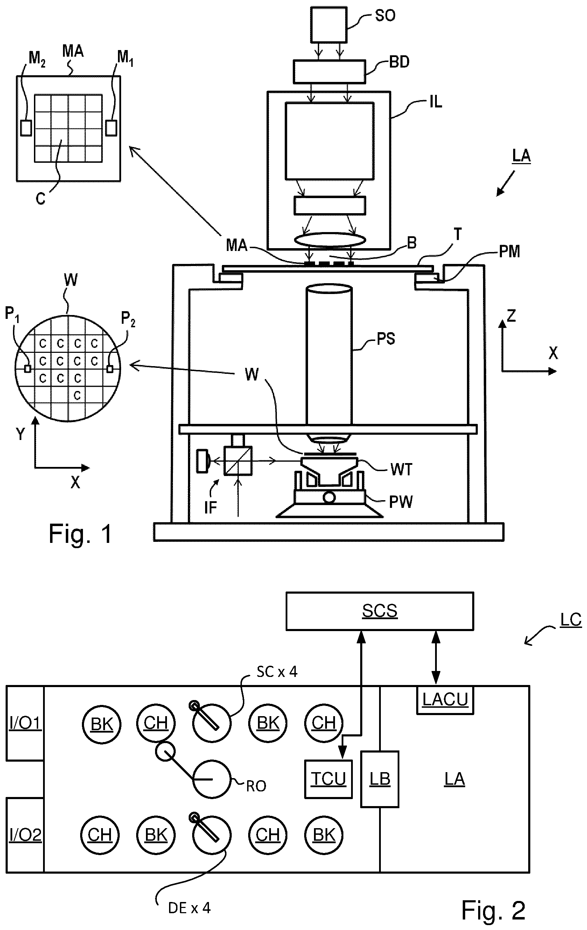

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR) soft X-ray (SXR), extreme ultraviolet (EUV), visible to near-IR and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered, which may be diffracted, reflected or transmitted, radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after other manufacturing process, etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

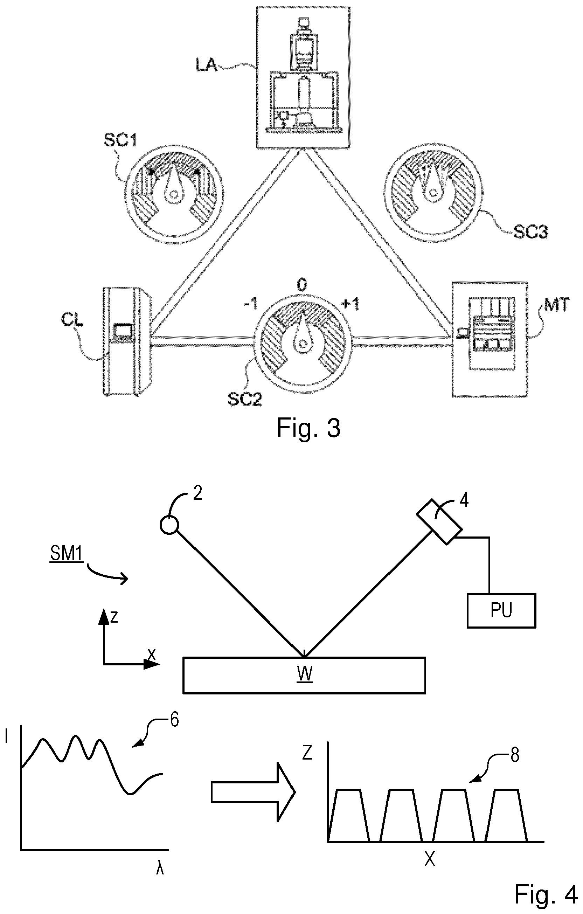

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic pattering apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

In lithographic processes, it is desirable to make frequently measurements of the structures created, e.g., for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometter illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target.

Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers can measure in one image multiple targets from multiple gratings using light from soft x-ray, extreme ultraviolet and visible to near-IR wave range.

One example of metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength λ) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

A transmissive version of the example of a metrology apparatus, such as a scatterometer shown in Figure 4, is another example. The transmitted radiation is passed to a spectrometer detector, which measures a spectrum as discussed for Figure 4. Such a scatterometer may be configured as a normal-incidence scatterometer or an oblique-incidence scatterometer. Optionally, the transmissive version using hard X-ray radiation with wavelength < 1nm, optionally <0.1nm, optionally <0.01nm.

As an alternative to optical metrology methods, it has also been considered to use hard X-ray, soft X-rays or EUV radiation, for example radiation with at least one of the wavelength ranges: <0.01nm, <0.1nm, <1nm, between 0.01nm and 100nm, between 0.01nm and 50nm, between 1nm and 50nm, between 1nm and 20nm, between 5nm and 20nm, and between 10nm and 20nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication No. 2019 /003988A1, and in U.S. Patent Publication No. 2019 /215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling and x-ray mathematical model and an optical mathematical model through one or more common. The contents of the cited US patent applications are incorporated herein by reference in their entirety.

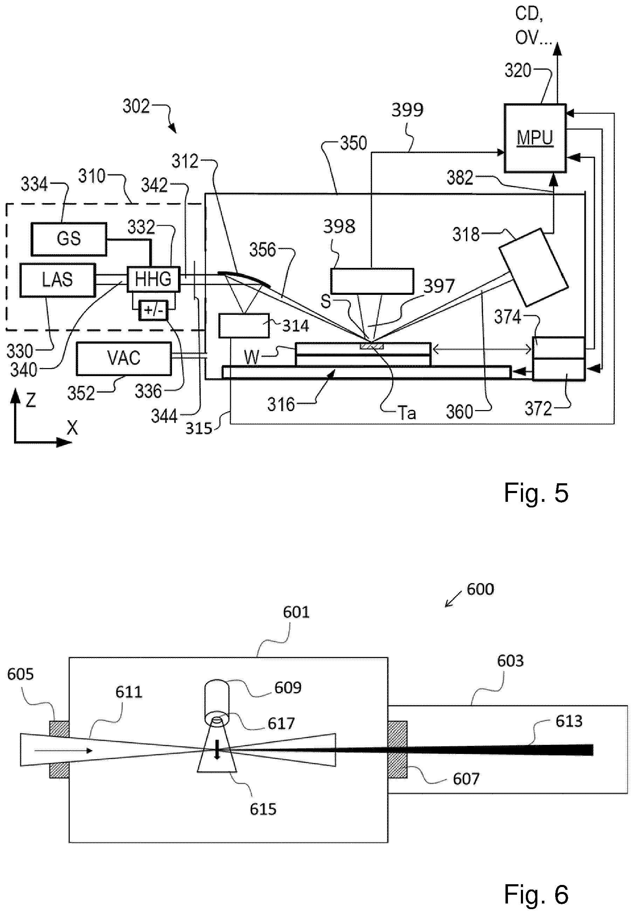

Figure 5 depicts a schematic representation of a metrology apparatus 302 in which the aforementioned radiation may be used to measure parameters of structures on a substrate. The metrology apparatus 302 presented in Figure 5 may be suitable for the hard X-ray, the soft X-rays and/or EUV domain.

Figure 5 illustrates a schematic physical arrangement of a metrology apparatus 302 comprising a spectroscopic scatterometer using hard X-ray, EUV and/or SXR radiation optionally in grazing incidence, purely by way of example. An alternative form of inspection apparatus might be provided in the form of an angle-resolved scatterometer, which may use radiation in normal or near-normal incidence similar to the conventional scatterometers operating at longer wavelengths, and which may also use radiation with direction being greater than 1° or 2° from a direction parallel to the substrate. An alternative form of inspection apparatus might be provided in the form of a transmissive scatterometer.

Inspection apparatus 302 comprises a radiation source or called illumination source 310, illumination system 312, substrate support 316, detection systems 318, 398 and metrology processing unit (MPU) 320.

An illumination source 310 in this example is for a generation of EUV, hard X-ray or soft X-ray radiation. The illumination source 310 may be based on high harmonic generation (HHG) techniques as shown in Figure 6, and it may also be other types of illumination sources, e.g. liquid metal jet source, inverse Compton scattering (ICS) source, plasma channel source, magnetic undulator source, free electron laser (FEL) source, compact storage ring source, electrical discharge produced plasma source, soft X-ray laser source, rotating anode source, solid anode source, particle accelerator source, microfocus source, or laser produced plasma source.

The HHG source may be a gas jet/nozzle source, a capillary/fiber source or a gas cell source.

For the example of HHG source, as shown in Figure 6, main components of the radiation source are a pump radiation source 330 operable to emit the pump radiation and a gas delivery system 332. Optionally the pump radiation source 330 is a laser, optionally the pump radiation source 330 is a pulsed high-power infrared or optical laser. The pump radiation source 330 may be, for example, a fiber-based laser with an optical amplifier, producing pulses of infrared radiation that may last for example less than 1 ns (1 nanosecond) per pulse, with a pulse repetition rate up to several megahertz, as required. The wavelength of the infrared radiation may be in the range 200nm to 10µm, for example in the region of 1 µm (1 micron). Optionally, the laser pulses are delivered as a first pump radiation 340 to the gas delivery system 332, wherein the gas a portion of the radiation is converted to higher frequencies than the first radiation into an emitted radiation 342. A gas supply 334 supplies a suitable gas to the gas delivery system 332, where it is optionally ionized by an electric source 336. The gas delivery system 332 may be a cut tube.

A gas provided by the gas delivery system 332 defines a gas target, which may be a gas flow or a static volume. The gas may be for example air, Neon (Ne), Helium (He), Nitrogen (N₂), Oxygen (O₂), Argon (Ar), Krypton (Kr), Xenon (Xe), Carbon dioxide and the combination of them. These may be selectable options within the same apparatus. The emitted radiation may contain multiple wavelengths. If the emitted radiation were monochromatic, then measurement calculations (for example reconstruction) may be simplified, but it is easier to produce radiation with several wavelengths. An emission divergence angle of the emitted radiation may be wavelength dependent. Different wavelengths will, for example, provide different levels of contrast when imaging structure of different materials. For inspection of metal structures or silicon structures, for example, different wavelengths may be selected to those used for imaging features of (carbon-based) resist, or for detecting contamination of such different materials. One or more filtering devices 344 may be provided. For example a filter such as a thin membrane of Aluminum (Al) or Zirconium (Zr) may serve to cut the fundamental IR radiation from passing further into the inspection apparatus. A grating (not shown) may be provided to select one or more specific wavelengths from among those generated. Optionally the illumination source comprises a space that is configured to be evacuated and the gas delivery system is configured to provide a gas target in the space. Optionally some or all of the beam path may be contained within a vacuum environment, bearing in mind that SXR and/or EUV radiation is absorbed when traveling in air. The various components of radiation source 310 and illumination optics 312 may be adjustable to implement different metrology 'recipes' within the same apparatus. For example different wavelengths and/or polarization may be made selectable.

Depending on the materials of the structure under inspection, different wavelengths may offer a desired level of penetration into lower layers. For resolving the smallest device features and defects among the smallest device features, then a short wavelength is likely to be preferred. For example, one or more wavelengths in the range 0.01-20 nm or optionally in the range 1-10 nm or optionally in the range 10-20 nm may be chosen. Wavelengths shorter than 5 nm may suffer from very low critical angle when reflecting off materials of interest in semiconductor manufacture. Therefore to choose a wavelength greater than 5 nm may provide stronger signals at higher angles of incidence. On the other hand, if the inspection task is for detecting the presence of a certain material, for example to detect contamination, then wavelengths up to 50 nm could be useful.

From the radiation source 310, the filtered beam 342 may enter an inspection chamber 350 where the substrate W including a structure of interest is held for inspection at a measurement position by substrate support 316. The structure of interest is labeled T. Optionally the atmosphere within inspection chamber 350 may be maintained near vacuum by vacuum pump 352, so that EUV radiation may pass with-out undue attenuation through the atmosphere. The Illumination system 312 has the function of focusing the radiation into a focused beam 356, and may comprise for example a two-dimensionally curved mirror, or a series of one-dimensionally curved mirrors, as described in published US patent application US2017/0184981A1 (which content is incorporated herein by reference in its entirety), mentioned above. The focusing is performed to achieve a round or elliptical spot S under 10 µm in diameter, when projected onto the structure of interest. Substrate support 316 comprises for example an X-Y translation stage and a rotation stage, by which any part of the substrate W may be brought to the focal point of beam to in a desired orientation. Thus the radiation spot S is formed on the structure of interest. Alternatively, or additionally, substrate support 316 comprises for example a tilting stage that may tilt the substrate W at a certain angle to control the angle of incidence of the focused beam on the structure of interest T.

Optionally, the illumination system 312 provides a reference beam of radiation to a reference detector 314 which may be configured to measure a spectrum and/or intensities of different wavelengths in the filtered beam 342. The reference detector 314 may be configured to generate a signal 315 that is provided to processor 320 and the filter may comprise information about the spectrum of the filtered beam 342 and/or the intensities of the different wavelengths in the filtered beam.

Reflected radiation 360 is captured by detector 318 and a spectrum is provided to processor 320 for use in calculating a property of the target structure T. The illumination system 312 and detection system 318 thus form an inspection apparatus. This inspection apparatus may comprise a hard X-ray, soft X-ray and/or EUV spectroscopic reflectometer of the kind described in US2016282282A1 which content is incorporated herein by reference in its entirety.

If the target Ta has a certain periodicity, the radiation of the focused beam 356 may be partially diffracted as well. The diffracted radiation 397 follows another path at well-defined angles with respect to the angle of incidence then the reflected radiation 360. In Figure 5, the drawn diffracted radiation 397 is drawn in a schematic manner and diffracted radiation 397 may follow many other paths than the drawn paths. The inspection apparatus 302 may also comprise further detection systems 398 that detect and/or image at least a portion of the diffracted radiation 397. In Figure 5 a single further detection system 398 is drawn, but embodiments of the inspection apparatus 302 may also comprise more than one further detection system 398 that are arranged at different position to detect and/or image diffracted radiation 397 at a plurality of diffraction directions. In other words, the (higher) diffraction orders of the focused radiation beam that impinges on the target Ta are detected and/or imaged by one or more further detection systems 398. The one or more detection systems 398 generates a signal 399 that is provided to the metrology processor 320. The signal 399 may include information of the diffracted light 397 and/or may include images obtained from the diffracted light 397.

To aid the alignment and focusing of the spot S with desired product structures, inspection apparatus 302 may also provide auxiliary optics using auxiliary radiation under control of metrology processor 320. Metrology processor 320 may also communicate with a position controller 372 which operates the translation stage, rotation and/or tilting stages. Processor 320 receives highly accurate feedback on the position and orientation of the substrate, via sensors. Sensors 374 may include interferometers, for example, which may give accuracy in the region of picometers. In the operation of the inspection apparatus 302, spectrum data 382 captured by detection system 318 is delivered to metrology processing unit 320.

As mentioned an alternative form of inspection apparatus uses hard X-ray, soft X-ray and/or EUV radiation optionally at normal incidence or near-normal incidence, for example to perform diffraction-based measurements of asymmetry. Another alternative form of inspection apparatus uses hard X-ray, soft X-ray and/or EUV radiation with direction being greater than 1° or 2° from a direction parallel to the substrate. Both types of inspection apparatus could be provided in a hybrid metrology system. Performance parameters to be measured may include overlay (OVL), critical dimension (CD), focus of the lithography apparatus while the lithography apparatus printed the target structure, coherent diffraction imaging (CDI) and at-resolution overlay (ARO) metrology. The hard X-ray, soft X-ray and/or EUV radiation may for example have wavelengths less than 100 nm, for example using radiation in the range 5-30 nm, of optionally in the range from 10 nm to 20 nm. The radiation may be narrowband or broadband in character. The radiation may have discrete peaks in a specific wavelength band or may have a more continuous character.

Like the optical scatterometer used in today's production facilities, the inspection apparatus 302 may be used to measure structures within the resist material treated within the litho cell (After Develop Inspection or ADI), and/or to measure structures after they have been formed in harder material (After Etch Inspection or AEI). For example, substrates may be inspected using the inspection apparatus 302 after they have been processed by a developing apparatus, etching apparatus, annealing apparatus and/or other apparatus.

Metrology tools MT, including but not limited to the scatterometers mentioned above, may use radiation from a radiation source to perform a measurement. The radiation used by a metrology tool MT may be electromagnetic radiation. The radiation may be optical radiation, for example radiation in the infrared, visible, and/or ultraviolet parts of the electromagnetic spectrum. Metrology tools MT may use radiation to measure or inspect properties and aspects of a substrate, for example a lithographically exposed pattern on a semiconductor substrate. The type and quality of the measurement may depend on several properties of the radiation used by the metrology tool MT. For example, the resolution of an electromagnetic measurement may depend on the wavelength of the radiation, with smaller wavelengths able to measure smaller features, e.g. due to the diffraction limit. In order to measure features with small dimensions, it may be preferable to use radiation with a short wavelength, for example EUV, hard X-ray and/or Soft X-Ray (SXR) radiation, to perform measurements. In order to perform metrology at a particular wavelength or wavelength range, the metrology tool MT requires access to a source providing radiation at that/those wavelength(s). Different types of sources exist for providing different wavelengths of radiation. Depending on the wavelength(s) provided by a source, different types of radiation generation methods may be used. For extreme ultraviolet (EUV) radiation (e.g. 1 nm to 100 nm), and/or soft X-ray (SXR) radiation (e.g. 0.1 nm to 10 nm), a source may use High Harmonic Generation (HHG) or any other types of illumination sources mentioned above to obtain radiation at the desired wavelength(s). One of the challenges faced in the development of these sources is how to couple the emitted radiation out of the generating setup efficiently and separate the emitted radiation from the radiation used to drive the process.

Figure 6 shows a simplified schematic drawing of an embodiment 600 of an illumination source 310, which may be the illumination source for high harmonic generation. One or more of the features of the illumination source in the metrology tool described with respect to Figures 5 may also be present in the illumination source 600 as appropriate. The illumination source 600 comprises a chamber 601. The illumination source 600 is configured to receive a pump radiation 611 with a propagation direction which is indicated by an arrow. The pump radiation 611 shown here is an example of the pump radiation 340 from the pump radiation source 330, as shown in Figure 5. The pump radiation 611 may be directed into the chamber 601 through the radiation input 605, which maybe a viewport which may be made of fused silica or a comparable material. The pump radiation 611 may have a Gaussian or hollow, for example annular, transversal cross-sectional profile and may be incident, optionally focused, on a gas flow 615, which has a flow direction indicated by a second arrow, within the chamber 601. The gas flow 615 comprises a small volume called gas volume or gas target (for example several cubic mm) of a particular gas (for example, air, Neon (Ne), Helium (He), Nitrogen (N₂), Oxygen (O₂), Argon (Ar), Krypton (Kr), Xenon (Xe), Carbon dioxide and the combination of them.) in which the gas pressure is above a certain value. The gas flow 615 may be a steady flow. Other media, such as metallic plasmas (e.g. aluminium plasma) may also be used.

The gas delivery system of the illumination source 600 is configured to provide the gas flow 615. The illumination source 600 is configured to provide the pump radiation 611 in the gas flow 615 to drive the generation of emitted radiation 613. The region where at least a majority of the emitted radiation 613 is generated is called an interaction region. The interaction region may vary from several tens of micrometers (for tightly focused pump radiation) to several mm or cm (for moderately focused pump radiation) or even up to a few meters (for extremely loosely focused pump radiation). The gas delivery system is configured to provide the gas target for generating the emitted radiation at the interaction region of the gas target, and optionally the illumination source is configured to receive the pump radiation and to provide the pump radiation at the interactive region. Optionally, the gas flow 615 is provided by the gas delivery system into an evacuated or nearly evacuated space. The gas delivery system comprises a gas nozzle 609, as shown in Figure 6, which may comprise an opening 617 in an exit plane of the gas nozzle 609. The gas flow 615 is provided from the opening 617. The gas catcher is for confining the gas flow 615 in a certain volume by extracting residual gas flow and maintaining a vacuum or near vacuum atmosphere inside the chamber 601. Optionally the gas nozzle 609 may be made of thick-walled tube and/or high thermo-conductivity materials to avoid thermo deformation due to the high-power pump radiation 611.

The dimensions of the gas nozzle 609 may conceivably also be used in scaled-up or scaled-down versions ranging from micrometer-sized nozzles to meter-sized nozzles. This wide range of dimensioning comes from the fact that the setup may be scaled such that the intensity of the pump radiation at the gas flow ends up in the particular range which may be beneficial for the emitted radiation, which requires different dimensioning for different pump radiation energies, which may be a pulse laser and pulse energies can vary from tens of microjoules to joules. Optionally, the gas nozzle 609 has a thicker wall to reduce nozzle deformation caused by the thermal expansion effect, which may be detected by e.g. a camera. The gas nozzle with thicker wall may produce a stable gas volume with reduced variation. Optionally, the illumination source comprises a gas catcher which is close to the gas nozzle to maintain the pressure of the chamber 601.

Due to interaction of the pump radiation 611 with the gas atoms of the gas flow 615, the gas flow 615 will convert part of the pump radiation 611 into the emitted radiation 613, which may be an example of the emitted radiation 342 shown in Figure 5. The central axes of the emitted radiation 613 may be collinear with the central axes of the incident pump radiation 611. The emitted radiation 613 may have a wavelength in X-ray or EUV range, wherein the wavelength is in a range from 0.01 nm to 100 nm, optionally from 0.1 nm to 100 nm, optionally from 1 nm to 100 nm, optionally from 1 nm to 50 nm, or optionally from 10 nm to 20 nm.

In operation the emitted radiation 613 beam may pass through a radiation output 607, e.g. an aperture or window, and may be subsequently manipulated and directed by an illumination system 603, which may be an example of the illumination system 312 in Figure 5, to a substrate to be inspected for metrology measurements. The emitted radiation 613 may be guided, optionally focused, to a structure on the substrate.

Because air (and in fact any gas) heavily absorbs SXR or EUV radiation, the volume between the gas flow 615 and the wafer to be inspected may be evacuated or nearly evacuated. Since the central axes of the emitted radiation 613 may be collinear with the central axes of the incident pump radiation 611, the pump radiation 611 may need to be blocked to prevent it passing through the radiation output 607 and entering the illumination system 603. This may be done by incorporating a filtering device 344 shown in Figure 6 into the radiation output 607, which is placed in the emitted beam path and that is opaque or nearly opaque to the pump radiation (e.g. opaque or nearly opaque to infrared or visible light) but at least partially transparent to the emitted radiation beam. The filter may be manufactured using zirconium or multiple materials combined in multiple layers. The filter may be a hollow, optionally an annular, block when the pump radiation 611 has a hollow, optionally an annular, transversal cross-sectional profile. Optionally, the filter is non-perpendicular and non-parallel to propagation direction of the emitted radiation beam to have efficient pump radiation filtering. Optionally, the filtering device 344 comprise a hollow block and a thin membrane filter such as an Aluminum (Al) or Zirconium (Zr) membrane filter. Optionally, the filtering device 344 may also comprise mirrors that efficiently reflect the emitted radiation but poorly reflect the pump radiation, or comprise a wire mesh that efficiently transmits the emitted radiation but poorly transmits the pump radiation.

Described herein are methods, apparatuses, and assemblies to obtain emitted radiation optionally at a high harmonic frequency of pump radiation. The radiation generated through the process, optionally the HHG which uses non-linear effects to generate radiation optionally at a harmonic frequency of provided pump radiation, may be provided as radiation in metrology tools MT for inspection and/or measurement of substrates. If the pump radiation comprises short pulses (i.e. few-cycle) then the generated radiation is not necessarily exactly at harmonics of the pump radiation frequency. The substrates may be lithographically patterned substrates. The radiation obtained through the process may also be provided in a lithographic apparatus LA, and/or a lithographic cell LC. The pump radiation may be pulsed radiation, which may provide high peak intensities for short bursts of time.

The pump radiation 611 may comprise radiation with one or more wavelengths higher than the one or more wavelengths of the emitted radiation. The pump radiation may comprise infrared radiation. The pump radiation may comprise radiation with wavelength(s) in the range of 500 nm to 1500 nm. The pump radiation may comprise radiation with wavelength(s) in the range of 800 nm to 1300 nm. The pump radiation may comprise radiation with wavelength(s) in the range of 900 nm to 1300 nm. The pump radiation may be pulsed radiation. Pulsed pump radiation may comprise pulses with a duration in the femtosecond range.

For some embodiments, the emitted radiation, optionally the high harmonic radiation, may comprise one or more harmonics of the pump radiation wavelength(s). The emitted radiation may comprise wavelengths in the extreme ultraviolet, soft X-Ray, and/or hard X-Ray part of the electromagnetic spectrum. The emitted radiation 613 may comprise wavelengths in one or more of the ranges of less than 1nm, less than 0.1nm, less than 0.01nm, 0.01 nm to 100 nm, 0.1 nm to 100 nm, 0.1 nm to 50 nm, 1 nm to 50 nm and 10 nm to 20 nm.

Radiation, such as high harmonic radiation described above, may be provided as source radiation in a metrology tool MT. The metrology tool MT may use the source radiation to perform measurements on a substrate exposed by a lithographic apparatus. The measurements may be for determining one or more parameters of a structure on the substrate. Using radiation at shorter wavelengths, for example at EUV, SXR and/or HXR wavelengths as comprised in the wavelength ranges described above, may allow for smaller features of a structure to be resolved by the metrology tool, compared to using longer wavelengths (e.g. visible radiation, infrared radiation). Radiation with shorter wavelengths, such as EUVSXR and/or HXR radiation, may also penetrate deeper into a material such as a patterned substrate, meaning that metrology of deeper layers on the substrate is possible. These deeper layers may not be accessible by radiation with longer wavelengths.

In a metrology tool MT, source radiation may be emitted from a radiation source and directed onto a target structure (or other structure) on a substrate. The source radiation may comprise EUVSXR and/or HXR radiation. The target structure may reflect, transmit and/or diffract the source radiation incident on the target structure. The metrology tool MT may comprise one or more sensors for detecting diffracted radiation. For example, a metrology tool MT may comprise detectors for detecting the positive (+1st) and negative (-1st) first diffraction orders. The metrology tool MT may also measure the specular reflected or transmitted radiation (0th order diffracted radiation). Further sensors for metrology may be present in the metrology tool MT, for example to measure further diffraction orders (e.g. higher diffraction orders).

In an example lithographic metrology application, the HHG generated radiation may be focused onto a target on the substrate using an optical column, which may be referred to as an illuminator, which transfers the radiation from the HHG source to the target. The HHG radiation may then be reflected from the target, detected and processed, for example to measure and/or infer properties of the target.

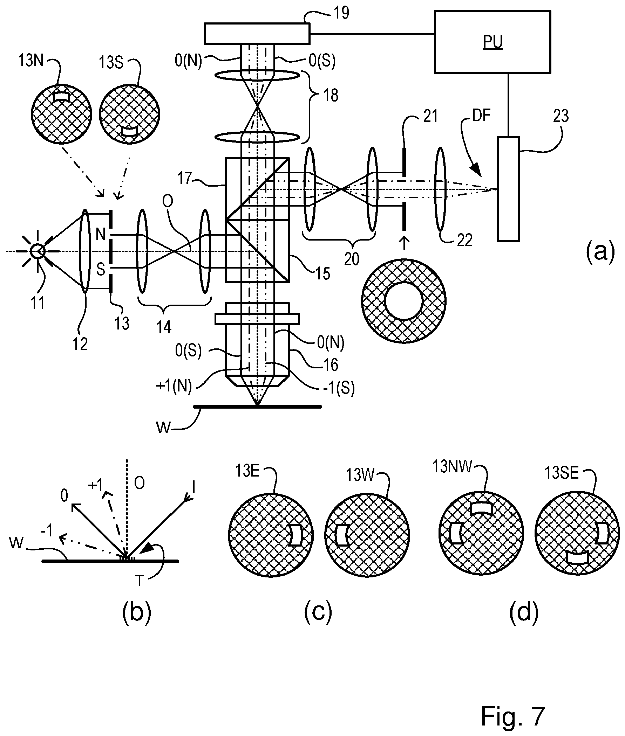

Gas target HHG configurations may be broadly divided into three separate categories: gas jets, gas cell and gas capillaries. Figure 7 depicts an example gas jet configuration in which as gas volume is introduced into a drive radiation laser beam. In a gas jet configuration, interaction of the drive radiation with solid parts is kept to a minimum. The gas volume may for example comprise a gas stream perpendicular to the drive radiation beam, with the gas volume enclosed inside a gas cell. In a gas capillary setup, the dimensions of the capillary structure holding the gas are small in a lateral direction such that it significantly influences the propagation of the drive radiation laser beam. The capillary structure may for example be a hollow-core fibre, wherein the hollow core is configured to hold the gas.

A gas jet HHG configuration may offer a relative freedom to shape a spatial profile of the drive radiation beam in the far field, as it is not confined by the restrictions imposed by the gas capillary structure. Gas jet configurations may also have less stringent alignment tolerances. On the other hand, a gas capillary may provide an increased interaction zone of the drive radiation and the gaseous medium, which may optimise the HHG process.

In order to use the HHG radiation, for example in a metrology application, it is separated from the drive radiation downstream of the gas target. The separation of the HHG and drive radiation may be different for the gas jet and gas capillary configurations. In both cases, the drive radiation rejection scheme can comprise a metal transmissive filter for filtering out any remaining drive radiation from the short wavelength radiation. However, before such a filter can be used, the intensity of the drive radiation should be reduced significantly from its intensity at the gas target, in order to avoid damage to the filter. The methods that can be used for this intensity reduction differ for the gas jet and capillary configurations. For a gas jet HHG, due to the relative freedom of the shape and spatial profile (which may also be referred to as a spatial distribution, and/or spatial frequencies) of the drive radiation beam focussed onto the gas target, this can be engineered such that in the far field it has a low intensity along the directions where the short wavelength radiation propagates. This spatial separation in the far field means an aperture may be used to block the drive radiation and lower its intensity

In contrast, in a gas capillary structure, the spatial profile of the beam as it passes through the gaseous medium may be largely dictated by the capillary. The spatial profile of the drive radiation may be determined by the shape and material of the capillary structure. For example, in the case of a hollow-core fiber being used as a capillary structure, the shape and materials of the fiber structure determine which modes of drive radiation are supported for propagation through the fiber. For most standard fibres, the supported propagating modes lead to a spatial profile where the high intensity of the drive radiation overlaps with the high intensity of the HHG radiation. For example, the drive radiation intensity may be centred, in a Gaussian or close-to-Gaussian profile in the far field.

A further metrology apparatus suitable for use in embodiments of the invention is shown in Figure 7(a). Note that this is only one example of a suitable metrology apparatus. An alternative suitable metrology apparatus may use EUV radiation such as, for example, that disclosed in WO2017/186483A1. A target structure T and diffracted rays of measurement radiation used to illuminate the target structure are illustrated in more detail in Figure 7(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 7(b), target structure T is placed with substrate W normal to the optical axis O of objective lens 16. The substrate W may be supported by a support (not shown). A ray of measurement radiation I (e.g., comprising SXR wavelengths) impinging on target structure T from an angle off the axis O gives rise to a zeroth order ray (solid line 0) and two first order rays (dot-chain line +1 and double dot-chain line -1). It should be remembered that with an overfilled small target structure, these rays are just one of many parallel rays covering the area of the substrate including metrology target structure T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the target structures and the illumination angles can be designed or adjusted so that the first order rays entering the objective lens are closely aligned with the central optical axis. The rays illustrated in Figure 7(a) and 7(b) are shown somewhat off axis, purely to enable them to be more easily distinguished in the diagram.

At least the 0 and +1 orders diffracted by the target structure T on substrate W are collected by objective lens 16 and directed back through beam splitter 15. Returning to Figure 7(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target structure on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target structure T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 5 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 5) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 7(c) and (d). The use of these, and numerous other variations and applications of the apparatus are described in prior published applications, mentioned above.

An illumination source such as the source 310 of Figure 5 or 600 of Figure 6 may comprise a Higher Harmonic Generation (HHG) source. Typically, there is a need to continuously or regularly measure characteristics of the radiation generated by the HHG source in the illumination branch, while the radiation is used to illuminate a structure (or called target) on a substrate, optionally a semiconductor wafer or a patterning device, in performing a measurement. In particular, real-time information on the spectral content of the source radiation should be measured. This can then be input to interference algorithms for inferring a parameter of interest of a target from the source radiation after being scattered by the target as well as diagnostics of the source.

The present method for achieving this is to provide a reference sub-branch within the illumination branch, with a portion of the source radiation directed into the reference sub-branch by a grating in the illumination branch. The grating may partly reflect the source radiation into the main illumination branch and partly diffract light into the reference sub-branch where it creates a spatially separated spectrum on a reference detector. This grating could be stand-alone grating, or a grating manufactured on a focusing mirror (one of the illuminator optics) of the illumination branch.

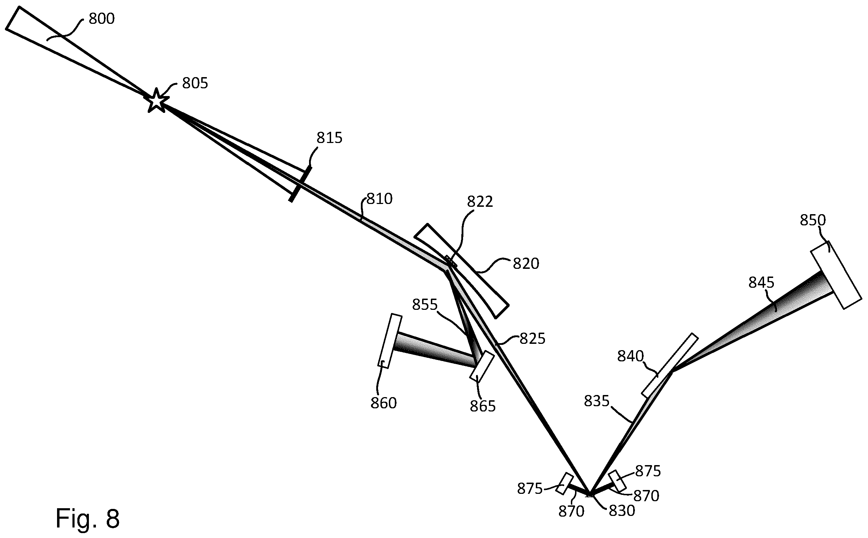

Figure 8 is a schematic illustration of such an arrangement. Pump radiation 800 (e.g., infra-red radiation) is focussed on a HHG generation point 805 (e.g., gas jet outlet) and used to generate HHG radiation (source radiation) 810. An aperture or spatial filter 815 blocks the pump radiation while admitting the source radiation 810. A focusing mirror 820 comprises a grating 822 which acts to split the source radiation 810 into measurement radiation 825 (e.g., the specularly reflected or zeroth order radiation of the scattered radiation scattered by the grating 822) and (dispersed) reference radiation 855 (e.g., one or both of the first diffraction orders of the scattered radiation scattered by the grating 822).

The measurement radiation 825 is used to measure a target 830 (e.g., in a particular, optional measurement method the target may be underfilled; i.e., the measurement spot is smaller than the target). First scattered radiation 870 (e.g., higher order or first order scattered radiation) may be detected (e.g., via optics not shown) by one or more measurement detector(s) 875. Additionally, second scattered radiation 835 (e.g., more specifically the zeroth order or specularly reflected radiation) from the target may be captured (e.g., via optics not shown). This scattered radiation 835 may then be dispersed by a dispersing element 840 (e.g., a grating), which is then detected on another measurement detector 850.

The dispersed reference radiation 855 may be detected by a reference detector 860, e.g., via beam steering optics such as mirror 865. A processor (not shown) may be used to determine a value for a parameter of interest from the first scattered radiation 870 and/or the dispersed scattered radiation 845 using the dispersed reference radiation 855 (as captured on the reference detector 860) as a reference (e.g., it may be required to know the spectral characteristics of the illumination prior to scattering by the target when determining a parameter of interest from the detected pattern on detector 875 and/or detector 850). The dispersed reference radiation 855 may also be used for monitoring the illumination source, e.g., to monitor illumination stability and/or monitor the spectral characteristics of the illumination.

Optionally there is one or more automatic feedback control loops for controlling the operation of the radiation source arrangements at least partly based on the signals detected by the reference detector 860 and or one or more of the measurement detectors 850, 875. Optionally there is a compensatory optical device placed before HHG generation point 805 for wavefront correction of the pump radiation 800. The compensatory optical device may be a programmable spatial light modulator (SLM) and/or a deformable mirror.

There are a number of problems with the configuration illustrated in Figure 8: The use of a grating 822 as a beamsplitter results in additional scattering within the specular beam. This makes it more difficult to underfill a small target. Also, within the wavelength range typically emitted by such an illumination source (e.g., 10-20nm), the grating typically generates orders higher than a first diffraction order, which leads to energy losses. The transmission to the wafer is thus reduced, leading to lower throughput. When designing illuminator optics, there are certain boundary conditions which should be met due to the aforementioned short wavelengths used. These boundary conditions may comprise, for example, having as few reflective surfaces as possible, having a grazing incidence angle as far away from normal as possible, providing a very smooth surface, having to place the reflective surfaces as close as possible to the target, having an as short as possible distance between the source generation point and the target and having not too small local radius of curvature of the surfaces. To include a grating in the design complicates this further, leading to compromises in the focus on target, the transmission of the illuminator, the size of the optical path and the demagnification of the illuminator. In addition, manufacturability of such a mirror with grating is very difficult. Placing a high-end grating onto a high-end mirror is high risk and complex in terms of sourcing.

Disclosed herein is a metrology apparatus for measuring a structure on a substrate, said structure having been patterned on the substrate, optionally in a lithographic process, the metrology apparatus comprising an illumination branch for directing measurement radiation onto a structure on a substrate, a measurement detector for detecting said measurement radiation subsequent to it being scattered by said structure, a pellicle beamsplitter in said illumination branch, said pellicle beamsplitter comprising a pellicle membrane operable to split source radiation from an illumination source into measurement radiation for measuring said structure and reference radiation, and a reference detector for detecting said reference radiation.

This concept is may also be used by EUV pellicle membranes to protect EUV reticles from contamination particles, by keeping such particles out of focus of the lithographic tool such that they are not imaged. These pellicles are designed (among other requirements) to have a low reflectivity/high transmission.

In an embodiment, it is proposed that the pellicle membrane used for the concepts disclosed herein is designed specifically for the beamsplitting application. As such, the pellicle membrane may be specifically designed to split off a small portion of the (e.g., SXR) measurement radiation beam. In an embodiment, transmission may be maximized, with the fraction split-off into the reference branch comprising less than 3%, less than 2%, less than 1.5%, less than 1.2% of the total energy of the incident beam. In combination with any of these upper percentage bounds, the fraction split-off into the reference branch may comprise more than 0.1%, more than 0.5%, more than 0.6 %, more than 0.7%, more than 0.8% or more than 0.9%. As such, in a specific embodiment, the fraction split-off into the reference branch may be between 0.5% and 1.5% or between 0.2% and 1.2% (e.g., approximately 1%).

Preferably, the spectral signature should be as low as possible (e.g., there should be a flat response over the relevant wavelength range). For example transmission and/or reflectivity of said pellicle membrane may vary by less than 35% by less than 30%, by less than 25%, less than 20%, less than 15% or less than 10% over a wavelength range of 10nm to 20nm, or over a wavelength range of 5nm to 30nm.

The pellicle beamsplitter may be used in combination with a dispersing element (e.g., a reference grating) to spectrally disperse the split-off beam prior to detection by the reference detector.

In an embodiment, the pellicle membrane may comprise three or more layers; e.g., comprising at least one outer layer on each side of at least one inner layer, wherein the at least one outer layer may be the same or different, and/or wherein optionally the at least one outer layer may have the same or different thicknesses, and/or wherein optionally the at least one outer layer may comprise the same or different materials. In an embodiment, the pellicle membrane may comprise two layers, wherein the two layers may be the same or different, and/or wherein optionally the two layers may have the same or different thicknesses, and/or wherein optionally the at two layers may comprise the same or different materials.

In an embodiment, the one or more outer layers on each side of the inner layer(s) may comprise and/or consist of one or more oxides. Such oxides may comprise, for example, one or more of a silicon oxide (e.g., SiO2), an aluminium oxide (e.g., Al₂O₃), a zirconium oxide (e.g., ZrO₂) or a Yttrium oxide (e.g., YO₂, or Y₂O₃). The oxide layer may function as a protective layer for the inner layer to provide e.g. mechanical, thermal or chemical stability. Moreover, the layer may function in the membrane to acquire the desired reflective properties as a function of wavelength.

In an embodiment, the outer layers may be as thin as possible while still ensuring a closed layer. Optionally a thickness of said at least one outer layer on a single side (or each side) of the at least one inner layer may be less than 4nm, or below 3nm; for example at thickness between 1nm and 3nm, between 1.5nm and 2.5nm, between 1.7nm and 2.3 nm, between 1.8nm and 2.2nm or between 1.9nm and 2.1nm (e.g., approximately 2nm).

A reason why the outer layer(s) should not be too thick is that the transmission of the oxides decreases, particularly for the longer wavelengths. Moreover, the (thickness of) the outer layer influences the reflectivity. A thick oxide layer result in a reflectivity having larger variation over the wavelengths. Its core function is a capping layer for chemical stability, for which should comprise fully closed layers. If the layer becomes too thin, islands will form such that the layer is no longer closed. This boundary is at about 1-1.5 nm, depending on the material.

The at least one inner layer may comprise one or more of a silicon or silicon compound layer (e.g., pure silicon Si, SiC, SiC₂, SiN, ZrSi) and/or a boron layer (e.g., pure boron B) or a Boron compound layer (e.g., B₄C, ZrB₂, BN) and/or zirconium, beryllium, niobium, yttrium, molybdenum, carbon and/or compounds of each of these or a mixture of these materials.

The inner layers may be as thin as possible in terms of manufacturability and tensile stresses; in an embodiment, a total inner layer thickness may be less than 20nm, less than 15nm, less than 10nm or less than 6 nm. In combination with any of these lower thickness bounds, the total inner layer thickness may be greater than 1nm, greater than 2nm, greater than 4nm, greater than 6nm, greater than 8nm, greater than 10nm or greater than 11nm.

Inner layer thickness is optimized for transmission, hence *a priori* thinner is better. In addition, the total layer stack cannot be too thin for mechanical stability, leading to lower boundaries. More layers can thus mean thinner individual layers, but the minimum layer thickness should still be about 1-2 nm to prevent island formation.

The angle of incidence of the source radiation beam on the beamsplitter (pellicle membrane) may be between 50 to 70 degrees, between 55 and 65 degrees, between 57 and 63 degrees between 59 and 61 degrees or more specifically about 60 degrees. Such an angle of incidence may provide optimal reflection/transmission. For basically all materials reflection dramatically increases for angles >70 degrees due to total external reflection. At the same time, reflection is very small (orders of magnitude) for angles near normal incidence. The optimizer balances reflection and transmission.

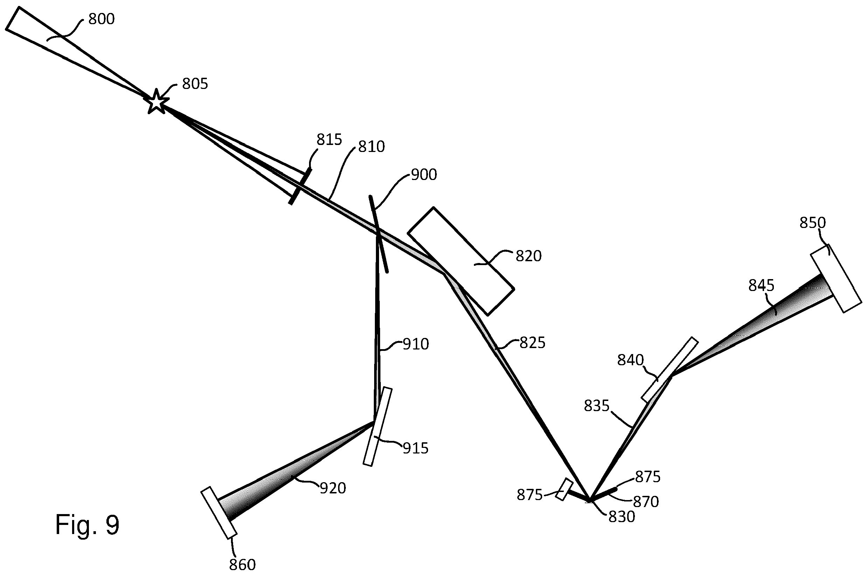

Figure 9 is a schematic diagram of a metrology apparatus according to an embodiment. The components and elements of the metrology apparatus common with the metrology apparatus illustrated in Figure 8 will not be described again. Here, a pellicle beamsplitter 900 is used in place of the grating, which splits the source radiation 810 into measurement radiation 825 and reference radiation 910. Reference radiation 910 may be dispersed using a dispersing element 915 to obtained spectrally dispersed reference radiation 920. This spectrally dispersed reference radiation 920 may then be detected using reference detector 860.

Also disclosed is a pellicle beamsplitter comprising a pellicle membrane, the pellicle membrane comprising three or more layers, the three or more layers comprising at least one inner layer and at least one outer layer on either side of said at least one inner layer, wherein the at least one inner layer comprises one or more of a silicon or silicon compound layer, and/or a boron layer (e.g., pure boron B) or a Boron compound layer (e.g., B₄C, ZrB₂, BN), and/or a zirconium, beryllium, niobium, yttrium, molybdenum and/or carbon layer and/or one or more compounds of each of these materials. The outer layers may comprise and/or consist of one or more oxides. Such oxides may comprise, for example, one or more of a silicon oxide (e.g., SiO₂), an aluminium oxide (e.g., Al₂O₃), a zirconium oxide (e.g., ZrO₂) or a Yttrium oxide (e.g., YO₂, or Y₂O₃). The pellicle membrane may comprise any of the thicknesses/dimensions disclosed above. Advantages of *inter alia* a Boron or a Boron compound, yttrium or a yttrium compound and/or carbon or a carbon compound for example is good transmission in the whole 10-20 nm wavelength range (Si has the silicon-edge).

Also disclosed is a pellicle beamsplitter comprising a pellicle membrane, the pellicle membrane comprising three or more layers, the three or more layers comprising at least one inner layer and at least one outer layer on either side of said at least one inner layer, wherein the at least one inner layer comprise a boron layer (e.g., pure boron B), a Boron compound layer (e.g., B₄C, ZrB₂, BN), a silicon layer, a zirconium, beryllium, niobium, yttrium, molybdenum and/or carbon layer and/or one or more compounds of each of these materials, wherein a combined thickness of said at least one outer layer on a single side (or each side) of the at least one inner layer is between 1nm and 3nm (e.g., between 1.5nm and 2.5nm, between 1.7nm and 2.3 nm, between 1.8nm and 2.2nm or between 1.9nm and 2.1nm) and the combined thickness of said inner layers is less than 20nm (e.g., less than 15nm, less than 13nm or less than or equal to 12 nm and optionally greater than 6nm, greater than 8nm, greater than 10nm or greater than 11nm).

The above described pellicle membrane designs can provide membranes with a transmission of 70%-80% and a reflection of 1%-2%, and with a very flat response over the wavelength range of interest (e.g., between 10 to 20nm). By contrast, commercially available EUV beamsplitters typically have a very poor (non-flat) spectral behavior and low transmission. By contrast with a grating beamsplitter such as illustrated in Figure 8, transmission (and thus throughput) is expected to be a factor of 5 larger, and manufacturing costs substantially less.

In all cases and embodiments, a total thickness of the pellicle membrane may be less than 20nm or less than 15nm.

While the above description has described pellicle membranes for use as a beamsplitter, the concepts and membranes disclosed may be used for other applications, such as for attenuation (e.g., to attenuate the high intensity full beam on camera during source beam profile monitoring), for filtering (e.g., for filtering out the infra-red drive radiation such as for filtering device 344 of Figure 5 or spatial filter 815 of Figure 9). Where used as an attenuation filter, for example, the pellicle membrane may be thicker than described in the context of beamsplitting; e.g., it may be thicker than 15nm or thicker than 20nm (e.g., up to 1.5µm).

More embodiments will now be described, mainly in the context of attenuation filtering or drive radiation/infra-red filtering (e.g., as filtering device 344 of Figure 5 or spatial filter 815 of Figure 9). However, the pellicle membrane of these further embodiments may also be used within the context of beamsplitting (e.g., as beamsplitter 900 of Figure 9). The membranes of all embodiments disclosed herein may be used in any situation where it is desirable to have a flat spectral transmission and/or reflection profile for a wavelength range of interest (e.g., SXR wavelengths).

The drive laser filter is presently performed using materials which have the highest ratio of SXR transmission to IR rejection. These filters rely on the transmission properties of the materials. Presently, these filters may comprise, for example, zirconium or aluminum thin film filters.

Typically, the structures being measured have a low diffraction efficiency. In addition to measuring the diffraction signal from such structures (on one or more diffraction signal detectors), the source beam profile may be periodically monitored, e.g., on a dedicated detector. Optionally, the dedicated detector is configured to receive the SXR illumination beam for source calibration prior to the beam being used to measure a structure (i.e., upstream of the wafer stage). Because this beam is measured directly before the low diffraction efficiency structure, the intensity can be very high.

Presently an attenuation filter may be used to attenuate this high intensity and avoid very low integration times on the detector(s). Presently, this attenuation may be done using a thick (e.g., 2µm or thicker) zirconium filter. Zirconium has the benefit of having its optimal transmission properties at a large thickness; if other materials are used, a filter with optimal transmission may be too thin to manufacture/handle.

By way of an example, a metrology tool calibration may comprise performing an alignment of the optics. This optical alignment may be performed with one or more detectors (e.g., cameras) placed at the main beam (SXR beam) focus. The measured intensity may be very high in such a case. When aligning the SXR optics in this way, the attenuation is also presently typically performed using with a zirconium filter.

Neutral density filters are commercially available for wavelengths down to 120nm; however at SXR wavelengths, there are no suitable examples commercially available. The attenuation of SXR wavelengths using thick zirconium filters changes the SXR spectrum (i.e., it does not act as a neutral filter over the wavelength range of interest). This is a problem as it is the "true" source profile which is being sought by the measurement. Therefore, when using a zirconium filter, monitoring of the source beam profile will be based on an incorrect spectral content. The beam profile is known to be wavelength dependent. This is also true of the focused SXR beam.

Not attenuating the SXR beam results in integration times on the detector which may be only a few milliseconds long, or even less than a millisecond. This is shorter than the minimum time in which the shutter can be opened and faster than most high-speed detectors. In addition, source powers may be increased significantly in the future, leading to impossible integration times if no attenuation is used.

Figure 10(a) is a plot 1000 of transmission Trn against wavelength λ for a zirconium filter (e.g., 1.2µm in this example). At this thickness, the long wavelength side of the SXR range is strongly attenuated. This will be even worse for higher source powers and/or in-focus beam measurement, due to the consequent requirement for thicker filters.

With an increasing source power, thicker filters will be required in order to achieve the required attenuation, leading to even stronger changes to the spectrum. For example, when using thick zirconium filters, only the short wavelength side of the SXR spectrum remains. Another commonly used material, aluminum, attenuates the short wavelengths and passes only the long wavelength side.

To address this, specific filter material combinations will be described which have a substantially or approximately spectrally flat response over a wavelength range of interest (e.g., between 10 to 20nm). The embodiments described here use a filter membrane or pellicle membrane which comprise two or more different materials, where at least one of the materials is germanium (Ge) or selenium (Se).

Most materials have a transmission in the 10-20nm region that is higher on the short wavelength side, such as the zirconium example illustrated in Figure 10(a). Very few materials show a qualitatively different behavior. Germanium and selenium are two examples that have an increasing transmission with increasing wavelength. Aluminum has an absorption edge which can approximate this behavior, but this results in strong spectral variations which is not ideal.

Figure 10(b) shows the equivalent plot to the spectral response plot of Figure 10(a) for germanium and Figure 10(c) shows the equivalent spectral response for selenium, which illustrates this desirable behavior.

Therefore it is proposed to construct a filter comprising a layer of one (or both) of germanium and selenium with one or more other materials in one or more further layers to obtain a filter membrane with an approximately flat spectral profile over the spectral range of interest. Using Ge or Se in combination with other materials, many combinations can be made which have the required spectral properties.

These layers can also be partially or completely mixed or compounded. This requires a more specialized manufacturing setup but probably would result in the same performance. Such an approach would create a filter having only a single layer.

Specific examples may include germanium and zirconium, boron, germanium and zirconium, carbon, germanium and zirconium or selenium and copper for example.

Figure 11 is a plot of the spectral responses (transmission Trn against wavelength λ) for each of these specific examples over a 10-20 nm wavelength range. Specifically, the plots relate to a germanium and zirconium filter 1110, a selenium and copper filter 1120 and a boron, germanium and zirconium filter 1130. For comparison, a zirconium and aluminum filter spectral response 1100 is also shown; this varies +/- 50% for most of its bandwidth and drops to zero transmission at 20 nm. By contrast the other three filters have much flatter responses over the shown range. As can be seen, for example, the three material combination boron, germanium and zirconium 1130 has a transmission that is flat within +/- 5% over the 10-20nm range.

While using two separate filters e.g. one Zr filter and one Al filter, will work as an alternative, a single combined filter such as disclosed herein has its advantages. The combined filter is thicker and mechanically stronger; it can also be cheaper to produce because the manufacturing procedure is easier. For example, the releasing process, which transfers a film on a substrate into a free standing membrane, needs to be performed only once.

The material combinations can also be implemented as successive discrete filters. However, thicker filters are mechanically stronger and can take a higher thermal load.

The proposed filter membrane may comprise transmission characteristics such that transmission variation is less than 50%, less than 40%, less than 30%, less than 20%, less than 10% or less than 5% over a wavelength range of between 10nm and 20nm.

In each filter combination comprising germanium, the germanium layer may be between 30nm and 450nm, between 50nm and 450nm, between 50nm and 300nm between 100nm and 300nm, between 120nm and 270nm or between 135nm and 150nm for example and the overall thickness may be between 100nm and 700nm, between 100nm and 500nm, between 100nm and 400nm, between 150nm and 400nm, between 200nm and 400nm, between 300nm and 400nm, 230nm and 270nm for example.

In each filter combination comprising selenium, the selenium layer may be between 30nm and 600nm, between 30nm and 500nm, between 30nm and 400nm, between 30nm and 400nm, between 30nm and 300nm. between 30nm and 200nm, between 30nm and 100nm, between 30nm and 70nm, or between 40nm and 60nm for example and the overall thickness may be between 50nm and 1.5µm, between 50nm and 1 µm, between 50nm and 800nm, between 50nm and 500nm, between 50nm and 300nm, between 50nm and 200nm or between 50nm and 150nm for example.

Any mention of first layer, second layer etc. or first material, second material etc. in the clauses and claims below should be understood to be for the purposes of differentiation only, and does not in any way imply a specific order of the layers or materials.

The filter membrane embodiments mentioned above may also use thin layers of the same materials instead of thick layers for beam splitting. The thicknesses of the thin layers may be the same as those of the layers of the pellicle membrane, which are mentioned above.

The pellicle membrane embodiments mentioned above may also use thick layers instead of thin layers for filtering. The thicknesses of the thick layers may be the same as those of the layers of the filter membrane, which are also mentioned above.

The above-mentioned embodiments may also be used as e.g. the filtering device 344 of Figure 5 as an IR blocker and SXR transmitter, and the spatial filter 815 of Figure 9 with a pinhole.

The above-mentioned membranes may be damaged during operation. The damage may be mitigated by periodically moving the membrane to find a new area which is not damaged or replacing the membrane. In the following embodiments, the filtering device 344 of Figure 5 is taken as an example, while the embodiments may be practiced for all the above-mentioned membranes, filters, films as well as mirrors and lenses.

The filtering device 344 of Figure 5 may comprise a metal transmissive membrane, which is commonly placed at normal incidence in the beam path. Optionally the metal transmissive membrane may be a 300 nm to 500 nm thick Zr filter comprising a Zr membrane. The Zr filter may be needed in spite of other filtering elements in upstream optical path because that some IR (referred as leaked IR) light always escapes due to scattering and imperfect alignment. Irradiated area by the leaked IR of the Zr filter may be damaged after long and continuous usage, optionally due to high temperature on the irradiated area and/or material (e.g. carbon) deposition. The damage and/or contamination may be detected by measuring the same and/or a different radiation reflected by the irradiated area. Note that the leaked IR is mentioned as an example for illustration purpose only, while the embodiments are applicable to any film, surface and/or interface irradiated by any types of radiation. A method is reported here for detecting damage and/or contamination optionally on the irradiated area caused by a first radiation, e.g. the leaked IR. The method comprises irradiating a second radiation, e.g. a probe beam, onto the irradiated area of the membrane, while the irradiated area of the membrane is also irradiated by the first radiation. The second radiation is reflected by the irradiated area to generate a reflected radiation, which is detected to obtain a signal. Based on the signal, damage and/or contamination information about the irradiated area is obtained.

In one embodiment, a laser as a probe beam, which is an example of the second radiation, is used to monitor the health of the Zr filter. The laser may be part of the IR drive laser beam transmitted through a mirror as the probe beam. A small portion of the IR light may transmit through a mirror due to the mirror's imperfect nature and/or a pinhole on the mirror. The small portion of the IR light, as the probe beam, can be reflected off the Zr filter from the same irradiated area where the leaked IR hits the Zr filter. Intensity of the probe beam reflected from the Zr filter may be measured by a probe detector, optionally a photodiode. The intensity of light measured by the photodiode is expected to stay constant over time if the Zr filter does not degrade. If the Zr filter becomes damaged over time, the signal measured by the photodiode will change. It has also been observed that the material e.g. carbon deposition built up on the Zr filter surface affects the SXR transmission. The carbon built up can also be monitored by the method. If a degradation of the Zr filter quality it detected, the Zr filter may be moved so that the SXR beam is transmitted through a new area which is not damaged.

The real-time time feedback of Zr filter quality may help in maintaining the transmitted SXR beam quality and ensure sufficient leaked IR suppression. The method may also prevent nonessential changing of Zr filters. The method may reduce the number of Zr filters needed over time. The method may also provide information about the contamination on Zr filter as well. There may be deposition of the hydrocarbon contaminants at surface of the Zr filter which are irradiated by laser pulses. The method may detect the presence of contaminants as it changes the reflectivity of the probe beam. The position of the Zr filter may be changed and the SXR may hit a new area without contaminations. It is expected that the intensity of the probe beam is much weaker than that of the leaked IR and therefore the probe beam does not affect the Zr filter.

In practice, the photodiode may be saturated by IR lights scattered from various optical components in the system. Therefore, accurate measurement of the probe beam signal may be difficult. Optionally, it is proposed to monitor polarization of the probe beam, optionally with a half wave plate, and use a polarizer in front of the photodiode to filter out the scattered IR light.

Optionally, a pair of balanced detectors instead of a single photodiode is used as probe detector. The probe beam is split into two beams by a beam splitter before reflecting off the Zr filter. One of the two beams is a reference probe beam, which is measured by a first detector of the pair of balanced detectors. The second detector of the pair of balanced detectors measures the other one of the two beams, which is the probe beam after reflecting from the Zr filter. When the Zr filter is not damaged or contaminated, the signals on the two detectors are balanced and a difference signal is measured, which should be tuned to zero. When the Zr filter is damaged or contaminated, the difference signal may change.

Optionally, the probe beam mentioned in the above embodiments may originate from a separate laser. The advantage is that the laser wavelength can be chosen such that it can be filtered at the detector(s) with a color filter. Therefore, it removes any scattered IR light. The separate laser can be cheap, and the embodiment reduces the complexity as well.

Optionally the intensity of the probe beam may be measured on a pulse-pulse basis. The above embodiments may include fast detectors e.g. fast photodiode(s). The intensity of each pulse after reflecting off the Zr filter can be measured. Optionally there is a delay between the leaked IR pulses and the probe beam pulses hitting the Zr filter. If the delay is chosen carefully, the temporal response of the Zr filter from the leaked IR can be measured. Before a metal surface is damaged due to accumulation of laser pulses, a short-lived change in refractive index may be observed, which is a precursor to the damage. Various other phenomena caused by different mechanisms, such as long-lived electron excitation, change in phonon coupling rate etc., can also be observed. A time resolved measurement can provide evidence of these phenomena. The time resolved measurement will act as an early indicator for the Zr filter damage, which could provide information about a possible damage to the Zr filter even before the Zr filter is damaged.

Optionally, the Zr filter is positioned with an angle oblique to the SXR optical path, and the reflected leaked IR is measured for direct monitoring of quality of the Zr filter. The angle of incidence of the source radiation beam on the Zr filter may be between 50 to 70 degrees, between 55 and 65 degrees, between 57 and 63 degrees, between 59 and 61 degrees or more specifically about 60 degrees. Such an angle of incidence may provide optimal reflection/transmission. The ranges of the angle of incidence balance reflection and transmission. One advantageous of having the Zr filter at between 50 to 70 degrees angle is for better IR suppression.

The above-mentioned embodiments provide a tool to monitor the quality of Zr filters and change the position of the Zr filter when/before it is damaged and/or contaminated, help in maintain the constant SXR transmission and IR suppression by detecting the presence of damages and/or contaminants on the Zr filter, and reduce the amount of Zr filter needed by monitoring its quality in real time.

The above-mentioned embodiments for detecting damage and/or contamination on the irradiated area caused by a radiation are also applicable to membrane elements, surface and interface of the lithographic apparatus using extreme ultraviolet (EUV) radiation.

The illumination source may be provided in for example a metrology apparatus MT, an inspection apparatus, a lithographic apparatus LA, and/or a lithographic cell LC.

The properties of the emitted radiation used to perform a measurement may affect the quality of the obtained measurement. For example, the shape and size of a transverse beam profile (cross-section) of the radiation beam, the intensity of the radiation, the power spectral density of the radiation etc., may affect the measurement performed by the radiation. It is therefore beneficial to have a source providing radiation that has properties resulting in high quality measurements.

Further embodiments are disclosed in the subsequent numbered clauses:
1. A metrology apparatus comprising:
   an illumination branch comprising illumination optics for directing a measurement radiation onto a structure;
   a pellicle beamsplitter in said illumination branch, said pellicle beamsplitter comprising a pellicle membrane operable to split a source radiation beam from an illumination source into a reference radiation beam and said measurement radiation;
   a measurement detector for detecting said measurement radiation subsequent to it being scattered by said structure; and
   a reference detector for detecting said reference radiation beam.
2. A metrology device as defined in clause 1, wherein said reference radiation beam comprises less than 3% of the total energy of said source radiation beam.
3. A metrology device as defined in clause 1, wherein said reference radiation beam comprises less than 1.5% the total energy of said source radiation beam.
4. A metrology device as defined in clause 1, 2 or 3, wherein said reference radiation beam comprises more than 0.1% of the total energy of said source radiation beam.
5. A metrology device as defined in clause 1, 2 or 3, wherein said reference radiation beam comprises more than 0.8% the total energy of said source radiation beam.
6. A metrology device as defined in any preceding clause, wherein transmission and/or reflectivity of said pellicle membrane varies by less than 25% over a wavelength range of 10nm to 20nm.
7. A metrology device as defined in any preceding clause, wherein transmission and/or reflectivity of said pellicle membrane varies by less than 20% over a wavelength range of 10nm to 20nm.
8. A metrology device as defined in any preceding clause, comprising a dispersing element between said pellicle beamsplitter and reference detector, being operable to spectrally disperse said reference radiation beam.
9. A metrology device as defined in any preceding clause, wherein the pellicle membrane comprises three or more layers, said three or more layers comprising at least one outer layer on each side of at least one inner layer.
10. A metrology device as defined in clause 9, wherein said at least one outer layer comprises an oxide material.
11. A metrology device as defined in clause 10, wherein said oxide material comprises one or more of a silicon oxide, an aluminum oxide, a zirconium oxide or an yttrium oxide.
12. A metrology device as defined in any of clauses 9 to 11, wherein a thickness of said at least one outer layer on each side of the at least one inner layer is less than 4nm.
13. A metrology device as defined in any of clauses 9 to 11, wherein a thickness of said at least one outer layer on each side of the at least one inner layer is less than 3nm.
14. A metrology device as defined in any of clauses 9 to 11, wherein a thickness of said at least one outer layer on each side of the at least one inner layer is less than 2.5nm.
15. A metrology device as defined in any of clauses 9 to 14, wherein a thickness of said at least one outer layer on each side of the at least one inner layer is greater than 1nm.
16. A metrology device as defined in any of clauses 9 to 14, wherein a thickness of said at least one outer layer on each side of the at least one inner layer is greater than 1.5nm.
17. A metrology device as defined in any of clauses 9 to 16, wherein the at least one inner layer comprises a silicon layer.
18. A metrology device as defined in any of clauses 9 to 17, wherein the at least one inner layer comprises and/or consists of one or more of a silicon, boron, zirconium, beryllium, niobium, yttrium, molybdenum and/or carbon and/or one or more compounds of each of these materials.
19. A metrology device as defined in any of clauses 9 to 18, wherein the at least one inner layer has a thickness less than 20nm.
20. A metrology device as defined in any of clauses 9 to 18, wherein the at least one inner layer has a thickness less than 15nm.
21. A metrology device as defined in any of clauses 9 to 18, wherein the at least one inner layer has a thickness less than 6nm.
22. A metrology device as defined in any of clauses 9 to 21, wherein the at least one inner layer has a thickness greater than 1nm.
23. A metrology device as defined in any of clauses 9 to 21, wherein the at least one inner layer has a thickness greater than 4nm.
24. A metrology device as defined in any preceding clause, wherein said source radiation beam comprises wavelengths in the range of 5nm to 30nm.
25. A metrology device as defined in any of clauses 1 to 23, wherein said source radiation beam comprises wavelengths in the range of 10nm to 20nm.
26. A metrology device as defined in any preceding clause, wherein an angle of incidence of the source radiation beam onto the pellicle membrane is between 45 to 70 degrees.
27. A metrology device as defined in any preceding clause, wherein an angle of incidence of the source radiation beam onto the pellicle membrane is between 55 to 65 degrees.
28. A metrology device as defined in any preceding clause, wherein said metrology device is configured for measuring a structure on a wafer, said structure having been exposed on the wafer in a lithographic process.
29. A metrology device as defined in any preceding clause, wherein the total thickness of the pellicle membrane is less than 20nm.
30. A metrology device as defined in any preceding clause, wherein the total thickness of the pellicle membrane is less than 15nm.
31. A pellicle membrane comprising three or more layers, the three or more layers comprising at least one inner layer and at least one outer layer on either side of said at least one inner layer, wherein the at least one inner layer comprises and/or consists of one or more of boron, zirconium, beryllium, niobium, yttrium, molybdenum and/or carbon and/or one or more compounds of each of these materials.
32. A pellicle membrane as defined in clause 31, wherein said at least one outer layer comprises an oxide material.
33. A pellicle membrane as defined in clause 32, wherein said oxide material comprises one or more of a silicon oxide, an aluminum oxide, a zirconium oxide or an yttrium oxide.
34. A pellicle membrane as defined in any of clauses 31 to 33, wherein a thickness of said at least one outer layer on each side of the at least one inner layer is less than 4nm.
35. A pellicle membrane as defined in any of clauses 31 to 33, wherein a thickness of said at least one outer layer on each side of the at least one inner layer is less than 3.5nm.
36. A pellicle membrane as defined in any of clauses 31 to 33, wherein a thickness of said at least one outer layer on each side of the at least one inner layer is less than 3nm.
37. A pellicle membrane as defined in any of clauses 31 to 33, wherein a thickness of said at least one outer layer on each side of the at least one inner layer is less than 2.5nm.
38. A pellicle membrane as defined in any of clauses 31 to 37, wherein a thickness of said at least one outer layer on each side of the at least one inner layer is greater than 1nm.
39. A pellicle membrane as defined in any of clauses 31 to 37, wherein a thickness of said at least one outer layer on each side of the at least one inner layer is greater than 1.5nm.
40. A pellicle membrane as defined in any of clauses 31 to 39, wherein the at least one inner layer comprises a silicon layer.
41. A pellicle membrane as defined in any of clauses 31 to 40, wherein the at least one inner layer comprises one or more of a boron layer or a boron compound layer.
42. A pellicle membrane as defined in any of clauses 31 to 41, wherein the at least one inner layer has a thickness less than 20nm.
43. A pellicle membrane as defined in any of clauses 31 to 41, wherein the at least one inner layer has a thickness less than 15nm.
44. A pellicle membrane as defined in any of clauses 31 to 41, wherein the at least one inner layer has a thickness less than 6nm.
45. A pellicle membrane as defined in any of clauses 31 to 44, wherein the at least one inner layer has a thickness greater than 1nm.
46. A pellicle membrane as defined in any of clauses 31 to 44, wherein the at least one inner layer has a thickness greater than 4nm.
47. A pellicle membrane as defined in any of clauses 31 to 46, wherein transmission and/or reflectivity of said pellicle membrane varies by less than 25% over a wavelength range of 10nm to 20nm.
48. A pellicle membrane as defined in any of clauses 31 to 47, wherein transmission and/or reflectivity of said pellicle membrane varies by less than 20% over a wavelength range of 10nm to 20nm.
49. A pellicle membrane as defined in any of clauses 27 to 48, wherein the total thickness of the pellicle membrane is less than 20nm.
50. A pellicle membrane as defined in any of clauses 27 to 48, wherein the total thickness of the pellicle membrane is less than 15nm.
51. A pellicle membrane comprising three or more layers, the three or more layers comprising at least one inner layer and at least one outer layer on either side of said at least one inner layer, wherein the at least one inner layer comprises and/or consists of one or more of a silicon, boron, zirconium, beryllium, niobium, yttrium, molybdenum and/or carbon and/or one or more compounds of each of these materials; and
   a thickness of said at least one outer layer on each side of the at least one inner layer is between 1 nm and 3nm.
52. A pellicle membrane as defined in clause 51, wherein the thickness of said at least one outer layer on each side of the at least one inner layer is between 1.5 nm and 2.5 nm.
53. A pellicle membrane as defined in clause 51, wherein said at least one outer layer comprises an oxide material.
54. A pellicle membrane as defined in clause 53, wherein said oxide material comprises one or more of a silicon oxide, an aluminum oxide, a zirconium oxide or a Yttrium oxide.
55. A pellicle membrane as defined in any of clauses 51 to 54, wherein the total thickness of the pellicle membrane is less than 20nm.
56. A pellicle membrane as defined in any of clauses 51 to 54, wherein the total thickness of the pellicle membrane is less than 15nm.
57. A pellicle membrane as defined in any of clauses 51 to 56, wherein the at least one inner layer has a thickness less than 20nm.
58. A pellicle membrane as defined in any of clauses 51 to 56, wherein the at least one inner layer has a thickness less than 15nm.
59. A pellicle membrane as defined in any of clauses 51 to 56, wherein the at least one inner layer has a thickness less than 6nm.
60. A pellicle membrane as defined in any of clauses 51 to 59, wherein the at least one inner layer has a thickness greater than 1nm.
61. A pellicle membrane as defined in any of clauses 51 to 59, wherein the at least one inner layer has a thickness greater than 4nm.
62. A pellicle membrane as defined in any of clauses 51 to 61, wherein transmission and/or reflectivity of said pellicle membrane varies by less than 25% over a wavelength range of 10nm to 20nm.
63. A pellicle membrane as defined in any of clauses 51 to 62, wherein transmission and/or reflectivity of said pellicle membrane varies by less than 20% over a wavelength range of 10nm to 20nm.
64. A pellicle beamsplitter comprising the pellicle membrane as defined in any of clauses 31 to 63.
65. An attenuator and/or drive radiation filter comprising the pellicle membrane as defined in any of clauses 31 to 63.
66. A filter membrane comprising at least two materials, wherein at least a first material of said at least two materials comprises or consists of germanium or selenium.
67. A filter membrane as defined in clause 66, comprising transmission characteristics such that transmission variation is less than 50% over a wavelength range of between 10nm and 20nm.
68. A filter membrane as defined in clause 66, comprising transmission characteristics such that transmission variation is less than 30% over a wavelength range of between 10nm and 20nm.
69. A filter membrane as defined in clause 66, comprising transmission characteristics such that transmission variation is less than 10% over a wavelength range of between 10nm and 20nm.
70. A filter membrane as defined in any of clauses 66 to 69, wherein said at least two materials is mixed or compounded into a single layer.
71. A filter membrane as defined in any of clauses 66 to 69, wherein each of said at least two materials is comprised in a respective separate layer.
72. A filter membrane as defined in any of clauses 66 to 71 where said first material comprises and/or consists of germanium and said at least two materials further comprises a second material which comprises and/or consists of zirconium.
73. A filter membrane as defined in clause 72, wherein said at least two materials further comprises a third material which comprises and/or consists of boron or carbon.
74. A filter membrane as defined in any of clauses 70 to 73, wherein a first layer of the membrane comprising said first material has a thickness between 30nm and 450nm.
75. A filter membrane as defined in any of clauses 70 to 73, wherein a first layer of the membrane comprising said first material has a thickness between 50nm and 300nm.
76. A filter membrane as defined in any of clauses 70 to 75, comprising an overall thickness between 100nm and 700nm.
77. A filter membrane as defined in any of clauses 70 to 75, comprising an overall thickness between 100nm and 500nm.
78. A filter membrane as defined in any of clauses 66 to 71 where said first material comprises and/or consists of selenium and said at least two materials further comprises a second material which comprises and/or consists of copper.
79. A filter membrane as defined in clause 78, wherein a first layer of the membrane comprising said first material has a thickness between 30nm and 600nm.
80. A filter membrane as defined in clause 78, wherein a first layer of the membrane comprising said first material has a thickness between 30nm and 400nm.
81. A filter membrane as defined in clause 78, 79 or 80, comprising an overall thickness between 50nm and 1.5µm.
82. A filter membrane as defined in clause 78, 79 or 80, comprising an overall thickness between 50nm and 500nm.
83. A beamsplitter, an attenuator and/or drive radiation filter comprising the filter membrane as defined in any of clauses 66 to 82.
84. A metrology apparatus comprising the beamsplitter, an attenuator and/or drive radiation filter of clause 83.
85. A method for detecting damage and/or contamination on an irradiated area caused by a first radiation, the method comprising:
   irradiating a second radiation onto the irradiated area, wherein the irradiated area is also irradiated by the first radiation, wherein the second radiation is reflected by the irradiated area to generate a reflected radiation,
   detecting the reflected radiation to obtain a signal, and
   obtaining damage and/or contamination information about the irradiated area based on the signal.
86. A method as defined in clause 85, wherein the irradiated area is an area of a membrane.
87. A method as defined in clause 85 or 86, wherein the first radiation is inferred.
88. A method as defined in any of clauses 85 to 87, wherein the second radiation is from the same source as the first radiation.
89. A method as defined in any of clauses 85 to 87, wherein the second radiation is from a different source than the first radiation.
90. A method as defined in any of clauses 85 to 89, wherein both the first radiation and the second radiation comprise pulses.
91. A method as defined in clause 90, wherein there is a delay between the first radiation and the second radiation.
92. A method as defined in any of clauses 85 to 91, wherein the reflected radiation is detected by a pair of balanced detectors.
93. A method as defined in any of clauses 85 to 92, wherein the second radiation is polarized.

Although specific reference may be made in this text to embodiments in the context of a reflective (or transmissive) membrane, embodiments may be used in transmissive (or reflective) membrane. One or more layers form different embodiments may be further combined to provide more advanced functions (e.g. less transmissive/reflective variation).

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments in the context of a lithographic apparatus, embodiments may be used in other apparatus. Embodiments may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (non-vacuum) conditions.

Although specific reference may be made in this text to embodiments in the context of an inspection or metrology apparatus, embodiments may be used in other apparatus. Embodiments may form part of a mask inspection apparatus, a lithographic apparatus, or any apparatus that measures or processes an object such as a wafer (or other substrate) or mask (or other patterning device). The term "metrology apparatus" (or "inspection apparatus") may also refer to an inspection apparatus or an inspection system (or a metrology apparatus or a metrology system). E.g. the inspection apparatus that comprises an embodiment may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference may have been made above to the use of embodiments in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

While specific embodiments have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference is made to HXR, SXR and EUV electromagnetic radiations, it will be appreciated that the invention, where the context allows, may be practiced with all electromagnetic radiations, includes radio waves, microwaves, infrared, (visible) light, ultraviolet, X-rays, and gamma rays.

While specific embodiments have been described above, it will be appreciated that one or more of the features in one embodiment may also be present in a different embodiment and that features in two or more different embodiments may also be combined.

## Claims

1. A pellicle membrane comprising three or more layers, the three or more layers comprising at least one inner layer and at least one outer layer on either side of said at least one inner layer, wherein the at least one inner layer comprises and/or consists of one or more of boron, zirconium, beryllium, niobium, yttrium, molybdenum and/or carbon and/or one or more compounds of each of these materials.

2. A pellicle membrane as claimed in claim 1, wherein said at least one outer layer comprises an oxide material, wherein optionally said oxide material comprises one or more of a silicon oxide, an aluminum oxide, a zirconium oxide or an yttrium oxide.

3. A pellicle membrane as claimed in claim 1 or 2, wherein a thickness of said at least one outer layer on each side of the at least one inner layer is less than 4nm and greater than 1nm.

4. A pellicle membrane as claimed in any of claims 1 to 3, wherein the at least one inner layer comprises a silicon layer.

5. A pellicle membrane as claimed in any of claims 1 to 4, wherein the at least one inner layer comprises one or more of a boron layer or a boron compound layer.

6. A pellicle membrane as claimed in any of claims 1 to 5, wherein the at least one inner layer has a thickness less than 6nm and greater than 1nm.

7. A pellicle membrane as claimed in any of claims 1 to 6, wherein transmission and/or reflectivity of said pellicle membrane varies by less than 25%, optionally less than 20%, over a wavelength range of 10nm to 20nm.

8. A pellicle membrane as claimed in any of claims 1 to 7, wherein the total thickness of the pellicle membrane is less than 20nm, optionally less than 15nm.

9. A metrology apparatus comprising:
an illumination branch comprising illumination optics for directing a measurement radiation onto a structure;
a pellicle membrane in said illumination branch, said pellicle membrane comprising a pellicle membrane operable to split a source radiation beam from an illumination source into a reference radiation beam and said measurement radiation;
a measurement detector for detecting said measurement radiation subsequent to it being scattered by said structure; and
a reference detector for detecting said reference radiation beam.

10. A metrology device as claimed in claim 9, wherein said reference radiation beam comprises less than 3% and more than 0.1% of the total energy of said source radiation beam.

11. A metrology device as claimed in claim 9 or 10, wherein transmission and/or reflectivity of said pellicle membrane varies by less than 25%, optionally less than 20%, over a wavelength range of 10nm to 20nm.

12. A metrology device as claimed in any of claims 9 to 11, wherein the pellicle membrane comprises three or more layers, said three or more layers comprising at least one outer layer on each side of at least one inner layer, wherein optionally said at least one outer layer comprises an oxide material, wherein optionally said oxide material comprises one or more of a silicon oxide, an aluminum oxide, a zirconium oxide or an yttrium oxide, wherein optionally a thickness of said at least one outer layer on each side of the at least one inner layer is less than 4nm and is greater than 1nm.

13. A metrology device as claimed in claim 12, wherein the at least one inner layer comprises and/or consists of one or more of a silicon, boron, zirconium, beryllium, niobium, yttrium, molybdenum and/or carbon and/or one or more compounds of each of these materials, wherein optionally the at least one inner layer comprises a silicon layer.

14. A metrology device as claimed in any of claims 9 to 13, wherein an angle of incidence of the source radiation beam onto the pellicle membrane is between 45 to 70 degrees, optionally between 55 to 65 degrees.

15. A pellicle membrane comprising a pellicle membrane, the pellicle membrane comprising three or more layers, the three or more layers comprising at least one inner layer and at least one outer layer on either side of said at least one inner layer, wherein the at least one inner layer comprises and/or consists of one or more of a silicon, boron, zirconium, beryllium, niobium, yttrium, molybdenum and/or carbon and/or one or more compounds of each of these materials; and a thickness of said at least one outer layer on each side of the at least one inner layer is between 1 nm and 3nm.
